# EUROPÄISCHE PATENTSCHRIFT

(11) **EP 2 302 295 B1**
(45) Veröffentlichungstag und Bekanntmachung des Hinweises auf die Patenterteilung: **24.12.2014**
(21) Anmeldenummer: 10179163.0
(22) Anmeldetag: 24.09.2010
(51) Int. Cl.: F21V 14/00, F21V 5/04, F21Y 101/02

(54) **Anordnung zur Lichtabgabe mit Lichtquelle und optischem Element**
Assembly for emitting light with light source and optical element
Agencement destiné à la sortie de lumière à l'aide d'une source lumineuse et d'un élément optique

(30) Priorität: 24.09.2009 DE 102009042906
(43) Veröffentlichungstag der Anmeldung: 30.03.2011
(73) Patentinhaber: Zumtobel Lighting GmbH, 6850 Dornbirn (AT)
(72) Erfinder: Ladstätter, Gerald, 6833 Klaus (AT)
(74) Vertreter: Thun, Clemens

(56) Entgegenhaltungen:
- EP-A2- 1 662 585
- WO-A2-2006/067653

## Beschreibung

Die vorliegende Erfindung betrifft eine Anordnung zur Lichtabgabe, welche eine Lichtquelle in Form einer LED sowie ein der Lichtquelle zugeordnetes optisches Element aufweist.

LEDs finden als Lichtquellen in der Beleuchtungstechnologie vermehrt Verwendung, da im Vergleich zu herkömmlichen Lichtquellen wie beispielsweise Gasentladungslampen usw. ein verhältnismäßig einfaches aber genaues Einstellen der Helligkeit realisierbar ist. Dies eröffnet die Möglichkeit, durch entsprechende Ansteuerung verschiedenfarbiger LEDs veränderbare Lichtfarben zu generieren, was zum Erzielen neuartiger Beleuchtungseffekte genutzt werden kann. Da in Beleuchtungsanwendungen veränderbares Licht einen stets wachsenden Stellenwert einnimmt, stellt die Möglichkeit einer Farbsteuerung einen bedeutenden Vorteil dar.

Neben der Möglichkeit, die Helligkeit und/oder die Farbe des abgegebenen Lichts einzustellen, wäre es bei bestimmten Anwendungen zusätzlich oder alternativ wünschenswert, die Richtungsabhängigkeit des abgegebenen Lichts einstellen zu können. Insbesondere bei sogenannten Strahlersystemen, bei denen LEDs als Lichtquellen zum Einsatz kommen, wäre eine Beeinflussung der Lichtverteilungskurve wünschenswert, um eine auf den jeweiligen Anwendungsfall optimale Ausleuchtung zu ermöglichen.

Der vorliegenden Erfindung liegt dementsprechend die Aufgabe zugrunde, eine neuartige Anordnung zur Lichtabgabe zur Verfügung zu stellen, bei der in einfacher aber effektiver Weise die Lichtabgabe beeinflusst werden kann.

Die Aufgabe wird durch eine Anordnung zur Lichtabgabe mit den Merkmalen des Anspruchs 1 gelöst. Vorteilhafte Weiterbildungen der Erfindung sind Gegenstand der abhängigen Ansprüche.

Die erfindungsgemäße Lösung beruht auf der Idee, als Primäroptik zur Beeinflussung der Lichtabgabe eine sogenannte Flüssiglinse zu verwenden, welche unmittelbar einer LED vorgeordnet ist.

Erfindungsgemäß wird dementsprechend eine Anordnung zur Lichtabgabe vorgeschlagen, mit einer Lichtquelle sowie einem der Lichtquelle zugeordneten optischen Element, wobei es sich bei der Lichtquelle um eine LED handelt und das optische Element durch eine Flüssiglinse gebildet ist, welche beabstandet vor der LED angeordnet ist.

Eine Flüssiglinse ist eine optische Linse mit elektrisch variierbarer Brennweite. Sie weist als wesentliche Bestandteile zwei nicht miteinander mischbare Flüssigkeiten von gleicher bzw. ähnlicher Dichte auf, welche allerdings einen unterschiedlichen Brechungsindex aufweisen. Durch ein elektrisches Feld wird mithilfe des Prinzips der sog. Elektrobenetzung die Benetzung einer Elektrode durch eine der beiden Flüssigkeiten beeinflusst, was zur Folge hat, dass sich die Grenzfläche zwischen den Flüssigkeiten und damit die Brennweite der Linse ändert. Dieses Konzept findet mittlerweile in Form von Mikrolinsen bei Kameras für Mobiltelefone Verwendung. Ferner wird in der DE 20 2007 004 527 U1 eine Taschenlampe mit fokussierbarer Optik vorgeschlagen, wobei eine LED als Lichtquelle am Boden eines Reflektors angeordnet ist, in dem eine entsprechende Flüssiglinse ausgebildet ist. Hier befindet sich also die LED bzw. der entsprechende Halbleiter-Chip innerhalb der Flüssiglinse.

Eine hochintegrierte Variante der Kombination von Flüssiglinse und LED-Lichtquelle wird beispielsweise im Rahmen eines komplizierten Herstellungsverfahrens in der EP 1 662 858 A2 beschrieben. Dabei soll ein LED-Chip mit einer Flüssiglinse vergossen werden.

Ferner ist aus der WO2006/067653 eine Anordnung zur Lichtabgabe bekannt die vorsieht eine Flüssiglinse, eine LED-Lichtquelle, die beispielsweise auch aus mehreren LED-Chips bestehen kann, sowie Treiberelektronik, die sowohl zur Steuerung der LEDs als auch zur Steuerung der Flüssiglinse ausgebildet ist, zu kombinieren. Dabei ist schematisch das Zusammenwirken der beabstandenten Komponenten angedeutet. Demgegenüber wird gemäß der vorliegenden Erfindung nunmehr vorgeschlagen, die Flüssiglinse beabstandet vor der LED anzuordnen, was deutliche Vorteile im Hinblick auf die Herstellung sowie die Funktionsfähigkeit der gesamten Anordnung mit sich bringt. Gleichzeitig wird durch die Nutzung der Flüssiglinse als Primäroptik für die LED die Möglichkeit eröffnet, die Lichtabgabe in einfacher und effektiver Weise zu beeinflussen.

Erfindungsgemäß wird die LED durch einen ungehäusten Halbleiter-Chip gebildet, der auf einem Trägerelement angeordnet ist. Hierbei handelt es sich um eine Platine, wobei gemäß der Erfindung die Flüssiglinse auf dem gleichen Trägerelement wie die zugehörige LED angeordnet ist.

Die Ansteuerung der Flüssiglinse erfolgt gemäß der Erfindung durch einen entsprechenden Treiber, der ebenfalls auf der Platine angeordnet ist. Dabei ist vorgesehen, dass der Treiber zusätzlich auch dazu ausgebildet ist, neben der Flüssiglinse die LED anzusteuern. Auf diese Weise wird ein abgestimmtes Verhalten von LED und zugeordneter Optik ermöglicht.

Vorzugsweise sind mehrere LEDs auf einer Platine angeordnet, wobei jeder LED dann jeweils eine Flüssiglinse zugeordnet ist. Gemäß einer alternativen Ausführungsform wäre es allerdings auch denkbar, mehrere LEDs einer gemeinsamen Flüssiglinse zuzuordnen. In diesem Fall wäre es insbesondere möglich, verschiedenfarbige LEDs zu verwenden, die jeweils in Gruppen einer Flüssiglinse zugeordnet sind.

Letztendlich wird durch die erfindungsgemäße Lösung also die Möglichkeit eröffnet, in einfacher Weise die Lichtabgabe einer LED zu beeinflussen. Die Anordnung zur Lichtabgabe der vorliegenden Erfindung eignet sich dementsprechend in besonders guter Weise für den Einsatz in Strahlern.

Nachfolgen soll die Erfindung anhand der beiliegenden Zeichnung näher erläutert werden. Es zeigen
- Fig. 1a und b: Schnittdarstellungen einer erfindungsgemäßen Anordnung zur Lichtabgabe mit einer LED und einer Flüssiglinse;
- Fig. 2: ein erstes Ausführungsbeispiel einer erfindungsgemäßen Anordnung mit mehreren LEDs in Aufsicht und
- Fig. 3: ein zweites Ausführungsbeispiel einer Anordnung mit mehreren LEDs.

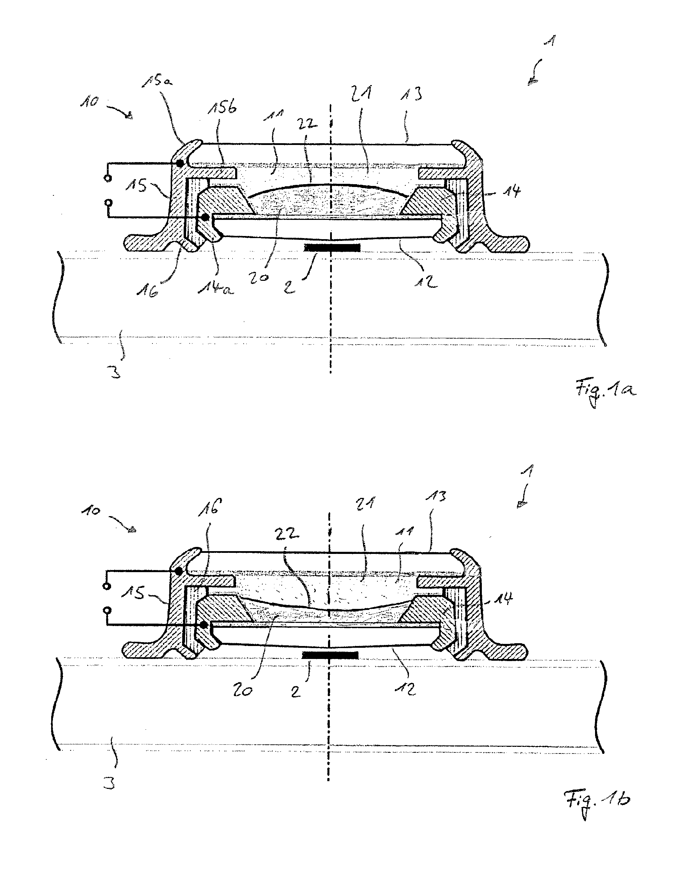

Die Figuren 1a und 1b zeigen seitliche Schnittdarstellungen einer erfindungsgemäßen Anordnung zur Lichtabgabe. Erster wesentlicher Bestandteil der allgemein mit dem Bezugszeichen 1 versehenen Anordnung ist eine Lichtquelle in Form eines LED-Chips 2, der ungehäust auf einer Leiterplatte bzw. Platine 3 angeordnet ist. Die ungehäuste Anordnung des LED-Chips 2 auf der Leiterplatte 3 ermöglicht eine maximale Lichtausbeute, so dass die erfindungsgemäße Anordnung 1 eine entsprechend hohe Effizienz aufweist und dementsprechend zu Beleuchtungszwecken genutzt werden kann.

Das von dem LED-Chip 2 emittierte Licht wird mit Hilfe einer dem Chip 2 vorgeordneten Optik beeinflusst, welche erfindungsgemäß durch eine allgemein mit dem Bezugszeichen 10 versehene Flüssiglinse gebildet ist. Auch diese Flüssiglinse 10 ist auf der Leiterplatte 3 montiert, so dass der LED-Chip 2 und die Flüssiglinse 10 eine kompakte Baueinheit bilden.

Zentraler Bestandteil der Flüssiglinse 10 ist ein Hohlraum 11, der an seiner dem LED-Chip 2 zugewandten Lichteintrittsseite sowie an der gegenüberliegenden Lichtaustrittsseite durch transparente Abdeckscheiben 12 bzw. 13 begrenzt wird. Die seitliche Begrenzung dieses Hohlraums 11 erfolgt durch zwei ringförmig ausgebildete Elektroden 14 und 15 sowie ein ebenfalls ringförmig ausgebildetes Isolierelement 16, welches die beiden Elektroden 14, 15 voneinander trennt. Die innere Elektrode 14 weist hierbei an ihrer Unterseite einen nach innen ragenden Vorsprung 14a auf, der eine umlaufende Auflagefläche für die Lichteintrittsscheibe 12 bildet und dementsprechend diese hält. In gleicher Weise umgreifen auch zwei obere Vorsprünge 15a und 15b der Elektrode 15 die Lichtaustrittsscheibe 13. Die äußere Elektrode 15 weist ferner an ihrem unteren Ende Stützabschnitte 15c auf, über die eine Montage auf der Leiterplatte bzw. Platine 3 erfolgt. Die beiden Elektroden 14 und 15 bilden auf diese Weise gemeinsam mit dem Isolierelement 16 eine umlaufende Mantelfläche, welche seitlich den Hohlraum 11 der Flüssiglinse 10 umschließt.

Innerhalb des Hohlraums 11 sind zwei Flüssigkeiten 20 und 21 angeordnet. Es handelt sich hierbei um verschiedene Flüssigkeiten, beispielsweise Öl und Wasser, welche jeweils einen unterschiedlichen Brechungsindex aufweisen. Beide Flüssigkeiten sind ferner nicht mischbar, so dass sich zwischen ihnen eine Trennschicht 22 ausbildet, an der die von dem LED-Chip 2 emittierten Lichtstrahlen beim Durchtritt gebrochen werden. Die Grenzfläche 22 ist hierbei entsprechend der Darstellung gekrümmt, so dass sich eine Linsenform ergibt, durch welche die Lichtstrahlen entsprechend beeinflusst bzw. gelenkt werden.

Die Form dieser Linse kann nunmehr dadurch beeinflusst werden, dass an die Elektroden 14 und 15 wahlweise eine entsprechende Spannung angelegt wird. Durch den sogenannten Elektrowetting-Effekt werden dabei die beiden Flüssigkeiten 20 und 21 unterschiedlich stark von der Zylinderwand der Elektrode 14 angezogen bzw. abgestoßen. Dies führt dazu, dass für den Fall, dass keine Spannung anliegt, sich eine Grenzfläche 22 zwischen den beiden Flüssigkeiten 20 und 21 entsprechend der Darstellung in Figur 1a ausbildet. Wird hingegen eine Spannung angelegt, nimmt die Grenzfläche eine Form entsprechend der Darstellung von Figur 1b an. Durch wahlweises Anlegen und Variieren der Spannung an den Elektroden 14 und 15 kann dementsprechend die Krümmung der Grenzfläche 22 und damit die Form der Flüssiglinse beeinflusst werden, was wiederum die Möglichkeit eröffnet, die Lichtverteilung des von dem LED-Chips 2 emittierten Lichts zu verändern.

Dadurch, dass nunmehr die Flüssiglinse 10 als unmittelbar der LED 2 vorgeordnete Primäroptik genutzt wird, wird eine sehr kompakte Einheit geschaffen, mit der in effektiver Weise Licht abgegeben und die Lichtverteilung in gewünschter Weise beeinflusst werden kann. Es wird auf diesem Wege eine sehr elegante Möglichkeit geschaffen, die räumliche Lichtabgabe zu verändern und den jeweiligen Bedürfnissen anzupassen. Wesentlich hierbei ist auch, dass die Flüssiglinse 10 dem LED-Chip 2 vorgeordnet ist bzw. eine Abdeckung des LED-Chips 2 bildet. Einerseits ist hierdurch der Chip 2 vor äußeren Einflüssen geschützt, andererseits kann das Licht nahezu vollständig zur Beleuchtung mit der gewünschten Lichtverteilung genutzt werden. Auch ist die erfindungsgemäße Konfiguration verhältnismäßig einfach herzustellen, was weitere Vorteile mit sich bringt.

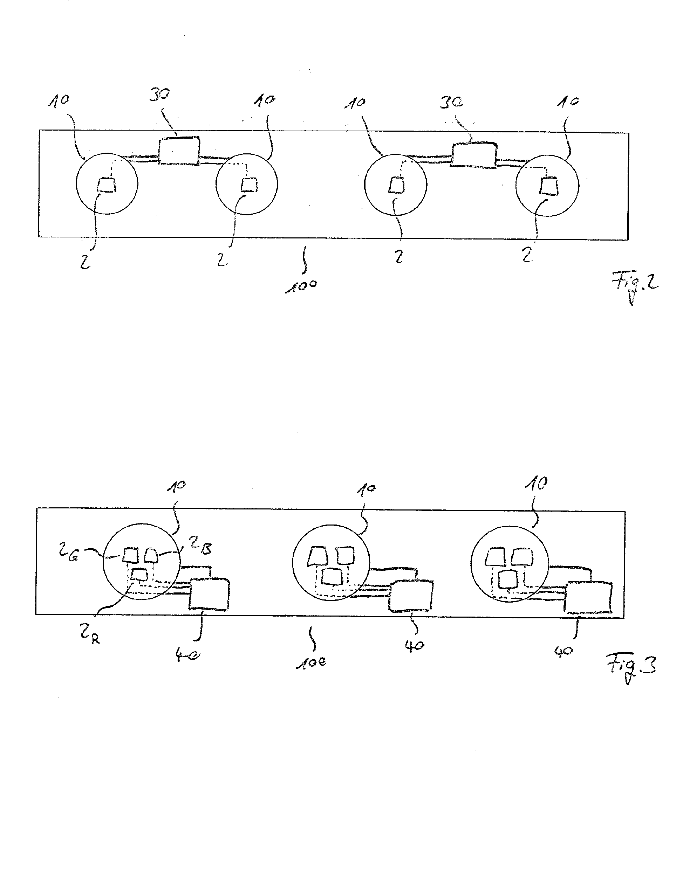

Anhand der Figuren 2 und 3 sollen nunmehr denkbare Ausführungsbeispiele bzw. Anwendungsfälle für die erfindungsgemäße Anordnung erläutert werden. Figur 2 zeigt hierbei eine längliche Leiterplatte 100, auf der voneinander beabstandet vier LED-Chips 2 angeordnet sind, denen jeweils eine Flüssiglinse 10 zugeordnet ist. Die Ansteuerung der LED-Chips 2 sowie der zugehörigen Flüssiglinse 10 erfolgt jeweils über einen Treiber 30, wobei im dargestellten Ausführungsbeispiel ein Treiber 30 für die Ansteuerung von jeweils zwei LEDs 2 zuständig ist. Der Treiber 30 übernimmt dabei nicht nur die Ansteuerung der LED-Chips 2 sondern auch der Flüssiglinsen 10, so dass ein aufeinander abgestimmtes Verhalten der Lichtabgabe und der Wirkung der Flüssiglinse 10 ermöglicht wird, um letztendlich eine kompakte Baueinheit zu erzielen.

Bei dem Ausführungsbeispiel von Figur 2 ist jeweils eine Flüssiglinse 10 einer LED 2 zugeordnet. Wie in Figur 3 dargestellt ist, wäre es allerdings auch denkbar, eine Flüssiglinse 10 jeweils einer Gruppe von LEDs zuzuordnen. Im dargestellten besonders vorteilhaften Ausführungsbeispiel bildet eine Flüssiglinse 10 nun die Primäroptik für eine Gruppe von jeweils drei LEDs 2_{R}, 2_{G}, 2_{B}, wobei es sich um verschiedenfarbige LEDs 2_{R}, 2_{G}, 2_{B} in den Farben Rot, Grün und Blau handelt. Diese Einheit bestehend aus den drei LEDs 2_{R}, 2_{G}, 2_{B} und der Flüssiglinse 10 wird wiederum von jeweils einem Treiber 40 angesteuert, wobei durch das aufeinander abgestimmte Ansteuern der verschiedenfarbigen LEDs 2_{R}, 2_{G}, 2_{B} nun auch die Möglichkeit besteht, Licht einer beliebigen gewünschten Mischfarbe zu erzeugen. Dieses wird dann insgesamt über die zugeordnete Flüssiglinse 10 abgegeben.

Bei dem Ausführungsbeispiel von Figur 3 besteht dementsprechend die Möglichkeit, die Richtungsabgabe bzw. die Lichtverteilung zu beeinflussen und des Weiteren auch die Farbe des abgegebenen Lichts einzustellen. Dementsprechend können hierbei Beleuchtungseffekte unterschiedlichster Art erzielt werden. Selbstverständlich wäre es allerdings auch denkbar, mehrere LEDs in gleicher Farbe einer Flüssiglinse zuzuordnen.

## Patentansprüche

1. Anordnung zur Lichtabgabe (1), mit einer Lichtquelle sowie einem der Lichtquelle zugeordneten optischen Element,
wobei es sich bei der Lichtquelle um eine LED (2) handelt,
das optische Element durch eine Flüssiglinse (10) gebildet ist, welche beabstandet vor der LED (2) angeordnet ist,
die LED (2) durch einen ungehäusten Halbleiter-Chip gebildet ist, der auf einer Platine angeordnet ist,
die Flüssiglinse (10) auf der gleichen Platine wie die zugehörige LED (2) angeordnet ist,
die Anordnung einen Treiber (30, 40) für die Flüssiglinse (10) aufweist, der ebenfalls auf der Platine angeordnet ist und
der Treiber (30, 40) dazu ausgebildet ist, neben der Flüssiglinse (10) auch die LED (2) anzusteuern.

2. Anordnung zur Lichtabgabe nach einem der vorherigen Ansprüche,
**dadurch gekennzeichnet,**
**dass** die Flüssiglinse (20) eine Abdeckung für die LED (10) bildet.

3. Anordnung zur Lichtabgabe nach einem der vorherigen Ansprüche,
**dadurch gekennzeichnet,**
**dass** mehrere LEDs (2) auf einer Platine (3) angeordnet sind, wobei jeder LED (2) jeweils eine Flüssiglinse (10) zugeordnet ist.

4. Anordnung zur Lichtabgabe nach einem der Ansprüche 1 oder 2,
**dadurch gekennzeichnet,**
**dass** mehrere LEDs (2_{R}, 2_{G}, 2_{B}) jeweils in Gruppen auf einer Platine (3) angeordnet sind, wobei den LED-Gruppen jeweils eine Flüssiglinse (10) zugeordnet ist.

5. Leuchte mit einer Anordnung zur Lichtabgabe nach einem der vorherigen Ansprüche.

6. Leuchte nach Anspruch5, wobei es sich bei der Leuchte um einen Strahler handelt.

## Claims

1. An arrangement for light-emission (1), having a light source and also an optical element associated with the light source,
wherein the light source is an LED (2),
the optical element is formed by a liquid lens (10) which is arranged at a distance in front of the LED (2),
the LED (2) is formed by a non-cased semiconductor chip which is arranged on a printed circuit board,
the liquid lens (10) is arranged on the same printed circuit board as the associated LED (2),
the arrangement has a driver (30, 40) for the liquid lens (10) that is likewise arranged on the printed circuit board, and
the driver (30, 40) is formed to activate the LED (2) also in addition to the liquid lens (10).

2. An arrangement for light-emission according to one of the previous claims,
**characterised in that**
the liquid lens (20) forms a cover for the LED (10).

3. An arrangement for light-emission according to one of the previous claims,
**characterised in that**
a plurality of LEDs (2) is arranged on a printed circuit board (3), wherein associated with each LED (2) there is, in each case, a liquid lens (10).

4. An arrangement for light-emission according to one of claims 1 or 2,
**characterised in that**
a plurality of LEDs (2_{R}, 2_{G}, 2_{B}) in each case in groups is arranged on a printed circuit board (3), wherein associated with the LED groups there is, in each case, a liquid lens (10).

5. A luminaire having an arrangement for light-emission according to one of the previous claims.

6. A luminaire according to claim 5, wherein the luminaire is a spotlight.

## Revendications

1. Ensemble servant à émettre de la lumière (1), comprenant une source de lumière ainsi qu'un élément optique associé à la source de lumière,
sachant que la source de lumière est une DEL (2),
que l'élément optique est formé par une lentille à base de liquide (10), qui est disposée à distance de la DEL (2),
que la DEL (2) est formée par une puce à semi-conducteurs sans boîtier, qui est disposée sur une platine,
que la lentille à base de liquide (10) est disposée sur la même platine que la DEL (2) associée,
que l'ensemble présente un pilote (30, 40) pour la lentille à base de liquide (10), qui est disposée de la même manière sur la platine, et
que le pilote (30, 40) est réalisé pour commander, en plus de la lentille à base de liquide (10), également la DEL (2).

2. Ensemble servant à émettre de la lumière selon l'une quelconque des revendications précédentes,
**caractérisé en ce**
**que** la lentille à base de liquide (20) forme un recouvrement pour la DEL (10).

3. Ensemble servant à émettre de la lumière selon l'une quelconque des revendications précédentes,
**caractérisé en ce**
**que** plusieurs DEL (2) sont disposées sur une platine (3), sachant que respectivement une lentille à base de liquide (10) est associée à chaque DEL (2).

4. Ensemble servant à émettre de la lumière selon l'une quelconque des revendications 1 ou 2,
**caractérisé en ce**
**que** plusieurs DEL (2_{R}, 2_{G}, 2_{B}) sont disposées respectivement dans des groupes sur une platine (3), sachant que respectivement une lentille à base de liquide (10) est associée aux groupes de DEL.

5. Appareil d'éclairage comprenant un ensemble servant à émettre de la lumière selon l'une quelconque des revendications précédentes.

6. Appareil d'éclairage selon la revendication 5, sachant que l'appareil d'éclairage est un projecteur.
